# EUROPEAN PATENT SPECIFICATION

(11) **EP 4 140 340 B1**
(45) Date of publication and mention of the grant of the patent: **04.06.2025**
(21) Application number: 21792968.6
(22) Date of filing: 22.04.2021
(51) Int. Cl.: A24F 40/57

(54) **AEROSOL GENERATION APPARATUS AND CONTROL METHOD THEREFOR**
AEROSOLERZEUGUNGSVORRICHTUNG UND STEUERUNGSVERFAHREN DAFÜR
APPAREIL GÉNÉRATEUR D'AÉROSOL ET SON PROCÉDÉ DE COMMANDE

(30) Priority: 22.04.2020 CN 202010323376
(43) Date of publication of application: 01.03.2023
(73) Proprietor: Shenzhen First Union Technology Co., Ltd., Shenzhen, Guangdong 518000 (CN)
(72) Inventor: YAN, Huiyong, Shenzhen, Guangdong 518000 (CN); LIANG, Kunxin, Shenzhen, Guangdong 518000 (CN); XU, Zhongli, Shenzhen, Guangdong 518000 (CN); LI, Yonghai, Shenzhen, Guangdong 518000 (CN)
(74) Representative: Proi World Intellectual Property GmbH
(86) International application number: PCT/CN2021/088973
(87) International publication number: WO 2021/213465

(56) References cited:
- EP-A1- 2 468 116
- WO-A1-2019/068821
- WO-A2-2019/088605
- CN-A- 106 461 589
- CN-A- 107 997 239
- CN-A- 109 007 976
- CN-A- 109 043 665
- CN-A- 109 793 285
- CN-A- 109 793 285
- CN-A- 110 279 153
- US-A1- 2017 360 097

## Description

The present application claims priority to the Chinese Patent Application No. 202010323376.1, filed on April 22, 2020 and entitled "AEROSOL GENERATION APPARATUS AND CONTROL METHOD THEREFOR".

### TECHNICAL FIELD

Embodiments of the present application relate to the technical field of smoking sets, and in particular relate to an aerosol generation apparatus and a control method therefor.

### BACKGROUND

Articles (such as cigarettes, cigars, etc.) burn tobacco during use to produce tobacco smoke. Attempts have been made to provide alternatives to these articles that bum tobacco by making products that release compounds without burning. Examples of such products are so-called heat-not-burn products, also known as tobacco heating products or tobacco heating devices, which release compounds by heating a material without burning the material. For example, the material may be tobacco or other non-tobacco products or a combination, such as a blended mixture which may or may not contain nicotine.

Application Publication No. CN110545682A discloses an aerosol generation device and method providing adaptive feedback based on smoking recognition, where a retainer uses a flow sensor and a temperature sensor to detect smoking of a user, and output is stopped when the number of remaining smokable times is below a critical value and the number of remaining smokable times is 0. CN109793285A discloses an aerosol generation device where user smoking is detected by monitoring the calculated power of the heater.

This solution has the problems that the costs of the sensors are high, and the size of a corresponding printed circuit board is large, which is not beneficial to product miniaturization.

### SUMMARY

Embodiments of the present application provide an aerosol generation apparatus and a control method therefor, and aim to solve the problem of using a sensor to detect smoking of a user in the existing aerosol generation apparatus.

A first aspect of the embodiments of the present application provides a control method for an aerosol generation apparatus, where the aerosol generation apparatus includes a heater for heating an aerosol generation substrate to generate an aerosol, and the method includes:
detecting whether a user smokes according to a real-time voltage value and a preset voltage threshold of the heater; and
when it is detected that the user smokes, calculating smoking duration when the real-time voltage value is greater than or equal to the preset voltage threshold.

A second aspect of the embodiments of the present application provides an aerosol generation apparatus. The aerosol generation apparatus includes a heater and a controller, and the controller is configured to execute the control method for an aerosol generation apparatus according to the first aspect.

A third aspect of the embodiments of the present application provides a non-volatile computer-readable storage medium, where the computer-readable storage medium stores computer-executable instructions that, when executed by the aerosol generation apparatus, cause the aerosol generation apparatus to execute the method as described above.

A fourth aspect of the embodiments of the present application provides a computer program product, where the computer program product includes a computer program stored on a non-volatile computer-readable storage medium, and the computer program includes program instructions that, when executed by an aerosol generation apparatus, cause the aerosol generation apparatus to execute the method as described above.

According to the control method for an aerosol generation apparatus provided by the embodiments of the present application, whether the user smokes is detected by means of the real-time voltage value and the preset voltage threshold of the heater, and then the smoking duration is calculated. On one hand, smoking of the user is detected without a flow sensor and a temperature sensor, which reduces the cost; and on the other hand, the size of a printed circuit board is reduced, which facilitates product miniaturization.

### BRIEF DESCRIPTION OF DRAWINGS

One or more embodiments are illustrated by pictures in the corresponding accompanying drawings, which are not intended to limit the embodiments, in which elements having the same reference numerals represent similar elements, and the figures of the accompanying drawings are not intended to constitute a scale limitation unless specifically stated otherwise.
FIG. 1 is a schematic diagram of an aerosol generation apparatus according to an embodiment of the present application;
FIG. 2 is a schematic diagram of a cigarette according to an embodiment of the present application;
FIG. 3 is a schematic diagram of a heating curve of a heater according to an embodiment of the present application;
FIG. 4 is a schematic diagram of a control flow of an aerosol generation apparatus according to an embodiment of the present application;
FIG. 5 is a schematic diagram of a circuit for detecting a real-time voltage value of a heater according to an embodiment of the present application;
FIG. 6 is a schematic diagram of an aerosol generation apparatus in smoking according to an embodiment of the present application;
FIG. 7 is a schematic diagram of another control flow of an aerosol generation apparatus according to an embodiment of the present application; and
FIG. 8 is a schematic structural diagram of a controller according to an embodiment of the present application.

### DETAILED DESCRIPTION

To facilitate the understanding of the present application, the present application will be described in more detail below with reference to the accompanying drawings and specific implementation. It should be noted that when an element is referred to as being "fixed to" another element, it can be directly on the other element or one or more intervening elements may be present therebetween. When an element is referred to as being "connected" to another element, it can be directly connected to the other element or one or more intervening elements may be present therebetween. As used herein, the terms "upper," "lower," "left," "right," "inner," "outer," and the like are for illustrative purposes only.

Unless defined otherwise, all technical and scientific terms used herein have the same meaning as commonly understood by those of ordinary skill in the technical field to which this application belongs. The terms used in the specification of the present application is for the purpose of describing specific embodiments only and is not used to limit the present application. As used herein, the term "and/or" includes any and all combinations of one or more of associated listed items.

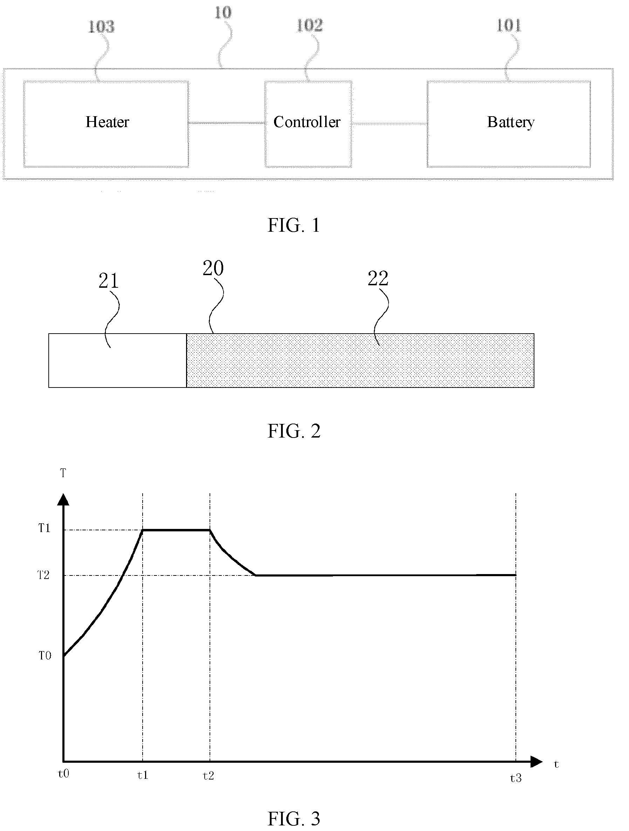

FIG. 1 is a schematic structural diagram of an aerosol generation apparatus according to an embodiment of the present application.

As shown in FIG. 1, the aerosol generation apparatus 10 includes a battery, 101, a controller 102 and a heater 103. In addition, the aerosol generation apparatus 10 has an interior space defined by a housing, and an aerosol generation article (e.g., a cigarette) can be inserted into the interior space of the aerosol generation apparatus 10.

Only elements, related to the present embodiment, of the aerosol generation apparatus 10 are shown in FIG. 1. Accordingly, it should be understood by those skilled in the art related to this embodiment that the aerosol generation apparatus 10 may further include general elements in addition to those shown in FIG. 1.

The battery 101 provides electric power for operating the aerosol generation apparatus 10. For example, the battery 101 can supply electric power to heat the heater 103 and can supply electric power needed to operate the controller 102. In addition, the battery 101 can supply electric power needed to operate other elements provided in the aerosol generation apparatus 10.

The battery 101 may be, but is not limited to, a lithium iron phosphate (LiFeP04) battery. For example, the battery 101 may be a lithium cobalt oxide (LiCo02) battery or a lithium titanate battery. The battery 101 may be a rechargeable battery or a disposable battery.

When a cigarette is inserted into the aerosol generation apparatus 10, the aerosol generation apparatus 10 heats the heater 103 by the electric power supplied by the battery 101. The heater 103 raises the temperature of an aerosol generation substrate in the cigarette to generate an aerosol. The generated aerosol is delivered to a user via a filter tip section of the cigarette for smoking. However, the aerosol generation apparatus 10 can also heat the heater 103 even if the cigarette is not inserted into the aerosol generation apparatus 10.

The heater 103 may be in a central heating manner (being in contact with the aerosol generation substrate by the periphery of a heating body or heating unit) or in a peripheral heating manner (the heating body or the heating unit wrapping the aerosol generation substrate), or the heater 103 may heat the aerosol generation substrate by means of one or more of thermal conduction, electromagnetic induction, chemical reaction, infrared action, resonance, photoelectric conversion, and photothermal conversion to generate the aerosol for smoking.

The controller 102 can control the overall operation of the aerosol generation apparatus 10. In detail, the controller 102 not only controls the operation of the battery 101 and the heater 103, but also controls the operation of other elements in the aerosol generation apparatus 10. In addition, the controller 102 can determine whether the aerosol generation apparatus 10 can be operated by checking the status of the elements of the aerosol generation apparatus 10.

The controller 102 includes at least one processor. The processor may include a logic gate array, or may include a combination of a general purpose microprocessor and a memory storing a program executable in the microprocessor. In addition, those skilled in the art should understand that the controller 102 may include another type of hardware.

For example, the controller 102 can control the operation of the heater 103. The controller 102 can control the amount of the electric power supplied to the heater 130 and the time for which the electric power is continuously supplied to the heater 103 such that the heater 103 is heated to a predetermined temperature or maintained at an appropriate temperature. In addition, the controller 102 can check the status of the battery 101 (e.g., the remaining power of the battery 101) and, if necessary, can generate a notification signal.

In addition, the controller 102 can check whether the user smokes and smoking duration, and can control the smoking duration. In addition, the controller 102 can check the time for continuous operation of the aerosol generation apparatus 10.

The aerosol generation apparatus 10 may include general elements in addition to the battery 101, the controller 102 and the heater 103.

For example, the aerosol generation apparatus 10 may include a display for outputting visual information or a motor for outputting tactile information. For example, when the display is included in the aerosol generation apparatus 10, the controller 102 can send information regarding the status of the aerosol generation apparatus 10 (e.g., whether the aerosol generation apparatus 10 can be used), information regarding the heater 103 (e.g., pre-heating start, pre-heating in progress, or pre-heating complete), information regarding the battery 101 (e.g., the remaining power of the battery 101, whether the battery 101 can be used), information regarding reset of the aerosol generation apparatus 10 (e.g., reset time, reset in progress, or reset complete), information regarding cleaning of the aerosol generation apparatus 10 (e.g., cleaning time, need to clean, cleaning in progress, or cleaning complete), information regarding charging of the aerosol generation apparatus 10 (e.g., need to charge, charging in progress, or charging complete), information regarding smoking (e.g., the number of smoking times and smoking end notification), or information regarding safety (e.g., use time) to the user. Alternatively, when the aerosol generation apparatus 10 includes the motor, the controller 102 can generate a vibration signal by using the motor and can send the information described above to the user.

In addition, the aerosol generation apparatus 10 may include at least one input device (e.g., a key) used by the user to control functions of the aerosol generation apparatus 10. For example, the user can perform various functions by using the input device of the aerosol generation apparatus 10. The desired function among the plurality of functions of the aerosol generation apparatus 10 can be performed by adjusting the number of times the user presses the input device (e.g., once or twice) or the time the user continues to press the input device (e.g., 0.1s or 0.2s). As the user operates the input device, the aerosol generation apparatus 10 can perform the function of heating the heater 103, the function of adjusting the temperature of the heater 103, the function of cleaning a space into which the cigarette is inserted, the function of checking whether the aerosol generation apparatus 10 can be operated, the function of displaying the remaining power (available electric power) of the battery 101, and the function of resetting the aerosol generation apparatus 10. However, the functions of the aerosol generation apparatus 10 are not limited thereto.

FIG. 2 is a schematic structural diagram of a cigarette according to an embodiment of the present application.

As shown in FIG. 2, a cigarette 20 includes a filter tip section 21 and a tobacco section 22.

The tobacco section 22 includes an aerosol generation substrate. The aerosol generation substrate is a substrate capable of releasing volatile compounds that can form an aerosol, and the volatile compounds can be released by heating the aerosol generation substrate.

The aerosol generation substrate may be a solid aerosol generation substrate. Alternatively, the aerosol generation substrate may include solid and liquid components. The aerosol generation substrate may include a tobacco-containing material containing volatile compounds with a tobacco flavor which are released from the substrate upon heating. Alternatively, the aerosol generation substrate may include a non-tobacco material. The aerosol generation substrate may further include an aerosol generation substance. Examples of suitable aerosol generation substances are glycerine and propylene glycol.

The aerosol produced by heating the tobacco section 22 is delivered to the user via the filter tip section 21, and the filter tip section 21 may be a cellulose acetate filter tip. The filter tip section 21 can be sprayed with flavoring liquid to provide fragrance, or separate fibers coated with the flavoring liquid can be inserted into the filter tip section 21 to improve the durability of the flavor delivered to the user. The filter tip section 21 may also have a capsule of a spherical or cylindrical shape, which may contain the contents of flavoring substances.

Only the components, related to the present embodiment, of the cigarette 20 are shown in FIG. 2. Accordingly, those skilled in the art related to this embodiment should understand that the cigarette 20 can further include general components in addition to those shown in FIG. 2, e.g., a cooling section for cooling the aerosol produced by heating the tobacco section 22, such that the user can inhale the aerosol cooled to a suitable temperature.

FIG. 3 is a schematic diagram of a heating curve of a heater 103 according to an embodiment of the present application.

As shown in FIG. 3, a temperature curve of the heater 103 over time includes a heating phase, a heat preservation phase, and a smoking phase.

In the heating phase, the temperature of the heater 103 is increased from an initial temperature T0 (or an ambient temperature) to a maximum temperature T1. Generally, T1 may be 200°C-400°C.

In the heat preservation phase, the temperature of the heater 103 is maintained at the preset target temperature T1 for a period of time, such that the aerosol generation substrate is sufficiently preheated to improve the smoking feeling of the user.

The duration of the heating phase is t0-t1, the duration of the heat preservation phase is t1-t2, and t0-t2 is preheating time of the heater 103. Generally, the preheating time of the heater 103 is 5s to 30s.

In the smoking phase, the temperature of the heater 103 drops from the maximum temperature to a target temperature T2, and the target temperature T2 is the best temperature at which the aerosol is generated by the aerosol generation substrate. In this phase, the temperature of the heater 103 is generally maintained at the target temperature T2 or fluctuates above and below the target temperature T2, and t2-t3 is the retaining time.

It should be noted that the heating curve of the heater 103 is not limited to the situation in FIG. 3. In other examples, it is also possible that the heating curve of the heater 103 has only the heating phase and the smoking phase.

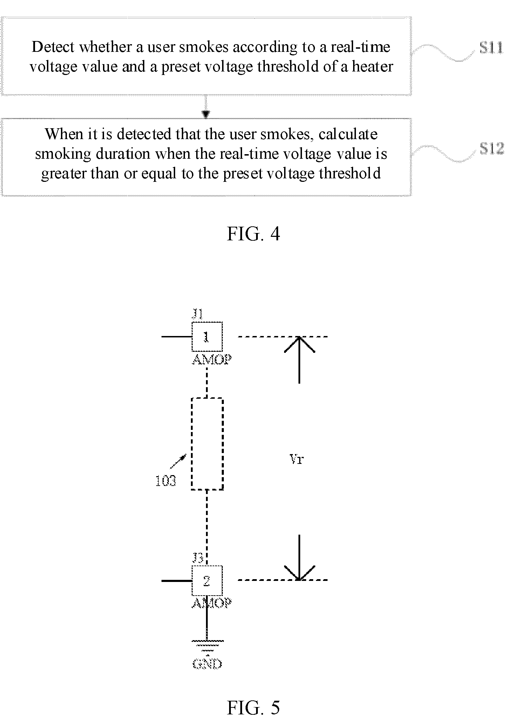

FIG. 4 is a schematic flowchart of a control method for an aerosol generation apparatus 10 according to an embodiment of the present application.

As shown in FIG. 4, in step S11, a controller 102 detects whether a user smokes according to a real-time voltage value and a preset voltage threshold of a heater 103.

Specifically, the real-time voltage value of the heater 103 can be detected by a voltage detection module (not shown in figure), and the controller 102 detects whether the user smokes according to the preset voltage threshold after acquiring the real-time voltage value of the heater 103 detected by the voltage detection module.

In this example, the preset voltage threshold may be an experimental value or empirical value. For the aerosol generation apparatus 10 having a single battery, the preset voltage threshold may be 1.5 V-2.5 V.

In an example, the step of detecting whether a user smokes according to a real-time voltage value and a preset voltage threshold of a heater includes:
if the real-time voltage value is greater than or equal to the preset voltage threshold, determining that the user smokes, and otherwise, determining that the user does not smoke.

In this example, the real-time voltage value of the heater 103 detected by the voltage detection module is compared with the preset voltage threshold to determine whether the user smokes.

The step of detecting whether a user smokes according to a real-time voltage value and a preset voltage threshold of a heater includes:
calculating an average voltage value in a preset time period according to the real-time voltage value; and
if the average voltage value is greater than or equal to the preset voltage threshold, determining that the user smokes, and otherwise, determining that the user does not smoke.

In this example, an effective voltage value of the heater 103, i.e., the average voltage value in the preset time period, is calculated according to the real-time voltage value of the heater 103 detected by the voltage detection module; and then, the effective voltage value of the heater 103 is then compared with the preset voltage threshold to determine whether the user smokes. Compared with the previous examples, this detection method is more accurate.

In step S12, when it is detected that the user smokes, the controller 102 calculates smoking duration when the real-time voltage value is greater than or equal to the preset voltage threshold.

Specifically, when it is detected in step S11 that the user smokes, the duration when the real-time voltage value of the heater 103 is greater than or equal to the preset voltage threshold can be recorded, where the duration is the smoking duration of this smoking of the user.

In an example, the method further includes:
calculating the sum of all smoking duration when the user smokes according to the smoking duration when the real-time voltage value is greater than or equal to the preset voltage threshold; and
if the sum of all the smoking duration is close to a first preset duration threshold, or the sum of all the smoking duration is greater than or equal to the first preset duration threshold, controlling the heater to stop heating.

In this example, the first preset duration threshold is 180s to 300s.

In this example, smoking duration of one-time smoking of the user is calculated in step S12, and then the sum of all the smoking duration when the user smokes is calculated.

If the sum of all the smoking duration is greater than or equal to the first preset duration threshold, the heater 103 is controlled to stop heating.

If the sum of all the smoking duration is close to the first preset duration threshold, the heater 103 is controlled to stop heating. "Close to" means that the remaining smoking duration is less than the smoking duration of one-time smoking of the user, and even if the user smokes, user experience is reduced due to an insufficient amount of smoke, such that the heater 103 can be controlled to stop heating in advance.

In an example, the method further includes:
after controlling the heater to enter a smoking phase, executing the step of detecting whether a user smokes according to a real-time voltage value and a preset voltage threshold of a heater.

In this example, it can be seen from the foregoing content and FIG. 3, for the heating curve of the heater 103 having the heating phase, the heat preservation phase, and the smoking phase, a detection step can be executed in the smoking phase, and prevented from being executed in the heating phase and the heat preservation phase.

In an example, the method further includes:
when it is detected that the user does not smoke, calculating duration when the user does not smoke; and
controlling the temperature of the heater to be reduced from a preset target temperature in the smoking phase to a first preset temperature if the duration when the user does not smoke is greater than or equal to a second preset duration threshold.

In this example, the duration when the user does not smoke is determined according to the duration when the real-time voltage value is less than the preset voltage threshold.

In this example, the temperature of the heater 103 is controlled to drop from the preset target temperature T2 in the smoking phase to the first preset temperature if it is detected that the user does not smoke in the smoking phase.

In an example, the method further includes:
controlling the temperature of the heater to rise from the first preset temperature to a second preset temperature when it is detected that the user smokes, where the second preset temperature is greater than the preset target temperature.

In this example, after the temperature of the heater 103 is controlled to drop from the preset target temperature T2 in the smoking phase to the first preset temperature, if it is detected that the user smokes, the temperature of the heater 103 is controlled to rise from the first preset temperature to the second preset temperature, where the second preset temperature is greater than the preset target temperature T2.

To better illustrate the present embodiment, the control process of the aerosol generation apparatus 10 is explained below in combination with FIG. 5-FIG. 7:

As shown in FIG. 5, two detection terminals of a voltage detection circuit are respectively connected to J1 and J3 to detect the real-time voltage value of the heater 103.

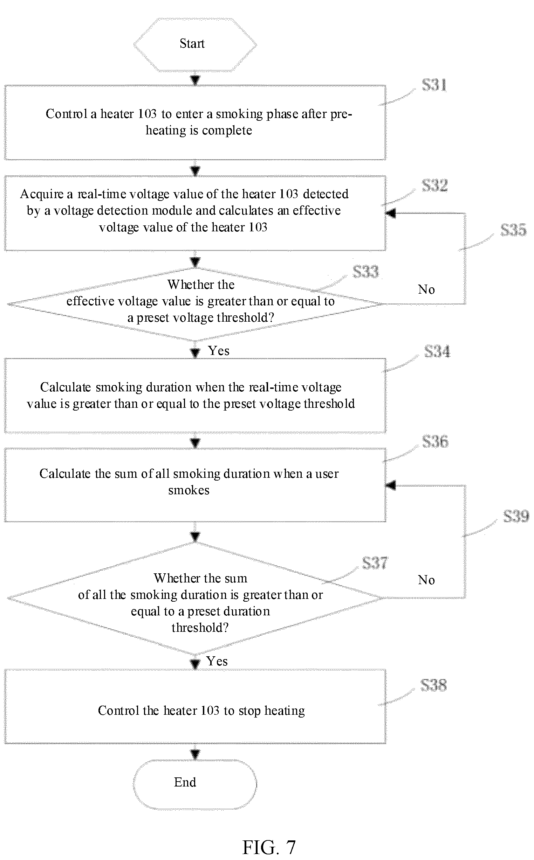

As shown in FIG. 7, after the aerosol generation apparatus 10 starts up, the controller 102 controls the heater 103 to enter the smoking phase after pre-heating is complete (step S31).

The controller 102 acquires the real-time voltage value of the heater 103 detected by the voltage detection module and calculates an effective voltage value of the heater 103 (step S32).

The controller 102 compares the effective voltage value of the heater 103 with a preset voltage threshold to determine whether the user smokes (step S33).

Specifically, as shown in FIG. 3, t2-t3 is the smoking phase of the heater 103. In the smoking phase of the heater 103, the power of the heater 103 may be a constant power value or approximately a constant power value, which can be determined by the formula P = U^2/R and the voltage value U of the heater 103 is also kept constant. When the user smokes, the power P of the heater 103 is increased accordingly, and it can be determined by the above formula that the voltage U of the heater 103 is also increased accordingly. Therefore, by comparing the effective voltage value of the heater 103 with the preset voltage threshold, it can be determined whether the user smokes.

If the effective voltage value of the heater 103 is greater than or equal to the preset voltage threshold, i.e. the user smokes, the smoking duration when the real-time voltage value is greater than or equal to the preset voltage threshold is calculated (step S34); and otherwise, the controller 102 continues to acquire the real-time voltage value of the heater 103 detected by the voltage detection module and calculates the effective voltage value of the heater 103 (step S35).

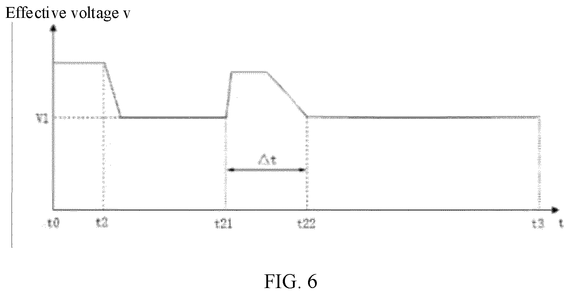

As shown in FIG. 6, t2-t3 is the smoking phase of the heater 103. From t21 to t22, the user smokes once. In this smoking duration, the real-time voltage value Vr of the heater 103 detected by the voltage detection module is greater than or equal to V1, and the smoking duration of this smoking of the user can be obtained by timing the time period Vr≥V1.

The controller 102 calculates the sum of all the smoking duration when the user smokes (step S36).

The controller 102 compares the sum of all the smoking duration with a preset duration threshold (step S37).

If the sum of all the smoking duration is greater than or equal to the preset duration threshold, the heater 103 is controlled to stop heating (step S38); and otherwise, the controller 102 continues to calculate the sum of all the smoking duration when the user smokes (step S39).

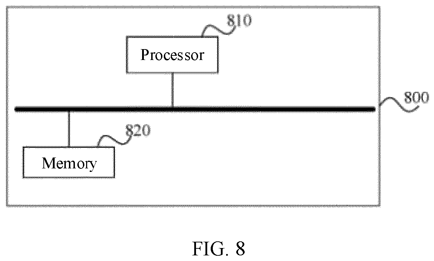

FIG. 8 is a schematic structural diagram of a controller 800 applied to a control method for an aerosol generation apparatus according to an embodiment of the present application. As shown in FIG. 8, the controller 800 includes:
one or more processors 810 and a memory 820, and one processor 810 is taken as an example in FIG. 8.

The processor 810 and the memory 820 can be connected by a bus or in other ways, and connection by a bus is taken as an example in FIG. 8.

The memory 820, as a non-volatile computer-readable storage medium, can be configured to store non-volatile software programs, non-volatile computer-executable programs and modules, such as program instructions/modules corresponding to the control method for an aerosol generation apparatus in embodiments of the present application. The processor 810 performs various functional applications and data processing of a server by running non-volatile software programs, instructions and modules stored in the memory 820, that is, implementing the control method for an aerosol generation apparatus according to the method embodiment described above.

The memory 820 may include a program storage region and a data storage region, where the program storage region can store an operating system, and an application program needed by at least one function; and the data storage region can store data created from the use of the aerosol generation apparatus or the like. In addition, the memory 820 may include a high-speed random access memory and may further include a non-volatile memory, e.g., at least one magnetic disk storage device, flash memory device, or another non-volatile solid-state memory device. In some embodiments, the memory 820 may optionally include memories located remotely with respect to the processor 810, and these remote memories can be connected to the aerosol generation apparatus via a network. Examples of the above network include, but are not limited to, the Internet, an intranet, a local area network, a mobile communication network, and combinations thereof.

The one or more modules are stored in the memory 820 and, when executed by the one or more processors 810, execute the control method for an aerosol generation apparatus according to any method embodiment described above, e.g., executing the method steps S11 and S12 in FIG. 4 and the method steps S31 to S39 in FIG. 7 described above.

The product can execute the method provided by the embodiment of the present application, and has functional modules and beneficial effects corresponding to method execution. For technical details which are not described in detail in this embodiment, refer to the method provided in the embodiment of the present application.

An embodiment of the present application provides a non-volatile computer-readable storage medium, where the computer-readable storage medium stores computer-executable instructions that, when executed by one or more processors, e.g., one processor 810 in FIG. 8, cause the one or more processors to be able to execute the control method for an aerosol generation apparatus according to any method embodiment described above, e.g., executing the method steps S11 and S12 in FIG. 4 and the method steps S31 to S39 in FIG. 7 described above.

The apparatus embodiments described above are merely illustrative, where the units illustrated as separate components may or may not be physically separate, and the components shown as units may or may not be physical units, that is, may be located in one place, or may also be distributed over a plurality of network units. A part or all of the modules can be selected according to actual needs to achieve the purpose of the solution of the embodiment.

From the above description of the embodiments, those of ordinary skill in the art can clearly understand that the various embodiments can be implemented by means of software and a general purpose hardware platform, and certainly can also be implemented by means of hardware. Those of ordinary skill in the art may understand that all or a part of procedures in the methods described above can be accomplished by instructing associated hardware by a computer program, can be stored in the computer-readable storage medium, and when executed, may include the flow of each method embodiment described above. The storage medium may be a magnetic disk, an optical disk, a read-only memory (ROM), a random access memory (RAM), or the like.

## Claims

1. A control method for an aerosol generation apparatus, wherein the method is applied to the aerosol generation apparatus, the aerosol generation apparatus comprises a heater for heating an aerosol generation substrate to generate an aerosol, and the method comprises:
detecting whether a user smokes according to a real-time voltage value and a preset voltage threshold of the heater; and being **characterized in that**
when it is detected that the user smokes, calculating smoking duration when the real-time voltage value is greater than or equal to the preset voltage threshold;
wherein the detecting whether the user smokes according to a real-time voltage value and a preset voltage threshold of the heater comprises:
calculating an average voltage value in a preset time period according to the real-time voltage value; and
if the average voltage value is greater than or equal to the preset voltage threshold, determining that the user smokes, and otherwise, determining that the user does not smoke.

2. The method according to claim 1, further comprising:
calculating the sum of all smoking duration when the user smokes according to the smoking duration when the real-time voltage value is greater than or equal to the preset voltage threshold; and
if the sum of all the smoking duration is close to a first preset duration threshold, or the sum of all the smoking duration is greater than or equal to the first preset duration threshold, controlling the heater to stop heating.

3. The method according to claim 2,
wherein the first preset duration threshold is 180s to 300s.

4. The method according to any one of claims 1-3, further comprising:
after controlling the heater to enter a smoking phase, executing the step of detecting whether a user smokes according to a real-time voltage value and a preset voltage threshold of the heater.

5. The method according to claim 4, further comprising:
when it is detected that the user does not smoke, calculating duration when the user does not smoke; and
controlling the temperature of the heater to be reduced from a preset target temperature in the smoking phase to a first preset temperature if the duration when the user does not smoke is greater than or equal to a second preset duration threshold.

6. The method according to claim 5, wherein the duration when the user does not smoke is determined according to the duration when the real-time voltage value is less than the preset voltage threshold.

7. The method according to claim 5 or 6, further comprising:
controlling the temperature of the heater to rise from the first preset temperature to a second preset temperature when it is detected that the user smokes, wherein the second preset temperature is greater than the preset target temperature.

8. An aerosol generation apparatus, wherein the aerosol generation apparatus comprises a heater and a controller, the heater is configured to heat an aerosol generation substrate to generate an aerosol, and the controller is configured to execute the control method for an aerosol generation apparatus according to any one of claims 1-7.

9. The aerosol generation apparatus according to claim 8. wherein the aerosol generation apparatus further comprises a voltage detection module, configured to detect a real-time voltage value of the heater.

10. A non-volatile computer-readable storage medium, wherein the computer-readable storage medium stores computer-executable instructions that, when executed by an aerosol generation apparatus according to claim 8, cause the aerosol generation apparatus to execute the method according to any one of claims 1-7.

11. A computer program product, wherein the computer program product comprises a computer program stored on a non-volatile computer-readable storage medium, and the computer program comprises program instructions that, when executed by an aerosol generation apparatus according to claim 8, cause the aerosol generation apparatus to execute the method according to any one of claims 1-7.

## Patentansprüche

1. Steuerungsverfahren für eine Aerosolerzeugungsvorrichtung, wobei das Verfahren auf die Aerosolerzeugungsvorrichtung angewendet wird, die Aerosolerzeugungsvorrichtung eine Heizvorrichtung zum Erhitzen eines Aerosolerzeugungssubstrats umfasst, um ein Aerosol zu erzeugen, und das Verfahren umfasst:
Erkennen, ob ein Benutzer raucht, in Abhängigkeit von einem Echtzeit-Spannungswert und einem voreingestellten Spannungsschwellenwert der Heizvorrichtung; und **dadurch gekennzeichnet, dass**
wenn erkannt wird, dass der Benutzer raucht, Berechnung der Rauchdauer, wenn der Echtzeit-Spannungswert größer oder gleich dem voreingestellten Spannungsschwellenwert ist;
wobei das Erkennen, ob der Benutzer raucht, gemäß einem Echtzeit-Spannungswert und einem voreingestellten Spannungsschwellenwert der Heizung umfasst:
Berechnung eines durchschnittlichen Spannungswertes in einer vorgegebenen Zeitspanne entsprechend dem Echtzeit-Spannungswert; und
wenn der durchschnittliche Spannungswert größer oder gleich dem voreingestellten Spannungsschwellenwert ist, die Feststellung, dass der Benutzer raucht, und andernfalls die Feststellung, dass der Benutzer nicht raucht.

2. Das Verfahren nach Anspruch 1 umfasst ferner:
Berechnen der Summe aller Rauchzeiten, wenn der Benutzer raucht, entsprechend der Rauchdauer, wenn der Echtzeit-Spannungswert größer oder gleich dem voreingestellten Spannungsschwellenwert ist; und
wenn die Summe aller Rauchdauern in der Nähe eines ersten voreingestellten Schwellenwerts für die Dauer liegt oder die Summe aller Rauchdauern größer oder gleich dem ersten voreingestellten Schwellenwert für die Dauer ist, das Heizgerät so zu steuern, dass es das Heizen beendet.

3. Verfahren nach Anspruch 2, wobei die erste voreingestellte Dauerschwelle 180s bis 300s beträgt.

4. Das Verfahren nach einem der Ansprüche 1 bis 3 umfasst ferner:
nach der Steuerung des Heizgeräts, um in eine Rauchphase einzutreten, Ausführen des Schritts des Erkennens, ob ein Benutzer raucht, gemäß einem Echtzeit-Spannungswert und einer voreingestellten Spannungsschwelle des Heizgeräts.

5. Das Verfahren nach Anspruch 4 umfasst ferner:
wenn erkannt wird, dass der Benutzer nicht raucht, Berechnung der Dauer, wenn der Benutzer nicht raucht; und
Steuerung der Temperatur des Heizgeräts, um von einer voreingestellten Zieltemperatur in der Rauchphase auf eine erste voreingestellte Temperatur reduziert zu werden, wenn die Dauer, in der der Benutzer nicht raucht, größer oder gleich einer zweiten voreingestellten Dauerschwelle ist.

6. Verfahren nach Anspruch 5, wobei die Dauer, in der der Benutzer nicht raucht, anhand der Dauer bestimmt wird, in der der Echtzeit-Spannungswert unter dem voreingestellten Spannungsschwellenwert liegt.

7. Das Verfahren nach Anspruch 5 oder 6 umfasst ferner:
Steuern der Temperatur des Heizelements, um von der ersten voreingestellten Temperatur auf eine zweite voreingestellte Temperatur anzusteigen, wenn erkannt wird, dass der Benutzer raucht, wobei die zweite voreingestellte Temperatur höher ist als die voreingestellte Zieltemperatur.

8. Aerosolerzeugungsvorrichtung, wobei die Aerosolerzeugungsvorrichtung eine Heizvorrichtung und eine Steuerung umfasst, die Heizvorrichtung so konfiguriert ist, dass sie ein Aerosolerzeugungssubstrat erhitzt, um ein Aerosol zu erzeugen, und die Steuerung so konfiguriert ist, dass sie das Steuerverfahren für eine Aerosolerzeugungsvorrichtung nach einem der Ansprüche 1 bis 7 ausführt.

9. Aerosolerzeugungsvorrichtung nach Anspruch 8, wobei die Aerosolerzeugungsvorrichtung ferner ein Spannungserfassungsmodul umfasst, das so konfiguriert ist, dass es einen Echtzeit-Spannungswert der Heizvorrichtung erfasst.

10. Nichtflüchtiges, computerlesbares Speichermedium, wobei das computerlesbare Speichermedium computerausführbare Anweisungen speichert, die, wenn sie von einer Aerosolerzeugungsvorrichtung nach Anspruch 8 ausgeführt werden, die Aerosolerzeugungsvorrichtung veranlassen, das Verfahren nach einem der Ansprüche 1 bis 7 auszuführen.

11. Computerprogrammprodukt, wobei das Computerprogrammprodukt ein Computerprogramm umfasst, das auf einem nichtflüchtigen, computerlesbaren Speichermedium gespeichert ist, und das Computerprogramm Programmanweisungen umfasst, die, wenn sie von einer Aerosolerzeugungsvorrichtung nach Anspruch 8 ausgeführt werden, die Aerosolerzeugungsvorrichtung veranlassen, das Verfahren nach einem der Ansprüche 1-7 auszuführen.

## Revendications

1. Méthode de contrôle pour un appareil de génération d'aérosol, dans laquelle la méthode est appliquée à l'appareil de génération d'aérosol, l'appareil de génération d'aérosol comprend un dispositif de chauffage pour chauffer un substrat de génération d'aérosol afin de générer un aérosol, et la méthode comprend :
détecter si un utilisateur fume en fonction d'une valeur de tension en temps réel et d'un seuil de tension prédéfini de l'appareil de chauffage ; et être **caractérisé en ce que**
lorsqu'il est détecté que l'utilisateur fume, calculer la durée du tabagisme lorsque la valeur de la tension en temps réel est supérieure ou égale au seuil de tension prédéfini ;
dans lequel la détection du tabagisme de l'utilisateur en fonction d'une valeur de tension en temps réel et d'un seuil de tension prédéfini de l'appareil de chauffage comprend :
calculer une valeur de tension moyenne dans une période de temps prédéfinie en fonction de la valeur de tension en temps réel ; et
si la valeur moyenne de la tension est supérieure ou égale au seuil de tension prédéfini, déterminer que l'utilisateur fume, et dans le cas contraire, déterminer que l'utilisateur ne fume pas.

2. La méthode selon la revendication 1, comprenant en outre :
calculer la somme de toutes les durées de tabagisme lorsque l'utilisateur fume en fonction de la durée de tabagisme lorsque la valeur de la tension en temps réel est supérieure ou égale au seuil de tension prédéfini ; et
si la somme de toutes les durées de fumage est proche d'un premier seuil de durée prédéfini, ou si la somme de toutes les durées de fumage est supérieure ou égale au premier seuil de durée prédéfini, commander l'arrêt du chauffage.

3. Méthode selon la revendication 2, dans laquelle le premier seuil de durée prédéfini est compris entre 180 et 300 secondes.

4. La méthode selon l'une des revendications 1 à 3, comprenant en outre :
après avoir commandé l'appareil de chauffage pour qu'il entre dans une phase de fumage, exécuter l'étape consistant à détecter si un utilisateur fume en fonction d'une valeur de tension en temps réel et d'un seuil de tension prédéfini de l'appareil de chauffage.

5. La méthode selon la revendication 4, comprenant en outre :
lorsqu'il est détecté que l'utilisateur ne fume pas, calculer la durée pendant laquelle l'utilisateur ne fume pas ; et
commander la réduction de la température du dispositif de chauffage d'une température cible prédéfinie pendant la phase de fumage à une première température prédéfinie si la durée pendant laquelle l'utilisateur ne fume pas est supérieure ou égale à un deuxième seuil de durée prédéfini.

6. Procédé selon la revendication 5, dans lequel la durée pendant laquelle l'utilisateur ne fume pas est déterminée en fonction de la durée pendant laquelle la valeur de la tension en temps réel est inférieure au seuil de tension prédéfini.

7. La méthode selon la revendication 5 ou 6, comprenant en outre :
contrôler la température du dispositif de chauffage pour qu'elle passe de la première température prédéfinie à une deuxième température prédéfinie lorsqu'il est détecté que l'utilisateur fume, la deuxième température prédéfinie étant supérieure à la température cible prédéfinie.

8. Appareil de génération d'aérosol, dans lequel l'appareil de génération d'aérosol comprend un dispositif de chauffage et un contrôleur, le dispositif de chauffage étant configuré pour chauffer un substrat de génération d'aérosol afin de générer un aérosol, et le contrôleur étant configuré pour exécuter la méthode de contrôle d'un appareil de génération d'aérosol selon l'une des revendications 1 à 7.

9. L'appareil de génération d'aérosol selon la revendication 8, dans lequel l'appareil de génération d'aérosol comprend en outre un module de détection de tension, configuré pour détecter une valeur de tension en temps réel de l'élément chauffant.

10. Support de stockage non volatile lisible par ordinateur, dans lequel le support de stockage lisible par ordinateur stocke des instructions exécutables par ordinateur qui, lorsqu'elles sont exécutées par un appareil de génération d'aérosol selon la revendication 8, amènent l'appareil de génération d'aérosol à exécuter la méthode selon l'une des revendications 1 à 7.

11. Produit programme d'ordinateur, dans lequel le produit programme d'ordinateur comprend un programme d'ordinateur stocké sur un support de stockage non volatile lisible par ordinateur, et le programme d'ordinateur comprend des instructions de programme qui, lorsqu'elles sont exécutées par un appareil de génération d'aérosol selon la revendication 8, amènent l'appareil de génération d'aérosol à exécuter la méthode selon l'une quelconque des revendications 1 à 7.
